Europäisches Patentamt

European Patent Office

Office européen des brevets

(19)

(11) Veröffentlichungsnummer: **0 065 684**

**A1**

(12) **EUROPÄISCHE PATENTANMELDUNG**

(21) Anmeldenummer: **82103974.0**

(22) Anmeldetag: **07.05.82**

(51) Int. Cl.³: **H 03 K 4/64**
**H 01 F 19/00**

(30) Priorität: **29.05.81 DE 3121278**

(43) Veröffentlichungstag der Anmeldung:
**01.12.82 Patentblatt 82/48**

(84) Benannte Vertragsstaaten:
**AT BE DE FR GB IT SE**

(71) Anmelder: **Licentia Patent-Verwaltungs-GmbH**
**Theodor-Stern-Kai 1**
**D-6000 Frankfurt/Main 70(DE)**

(72) Erfinder: **Goseberg, Walter, Dipl.-Ing.**
**Kopenhagenerstrasse 81**
**D-3000 Hannover 91(DE)**

(72) Erfinder: **Ernemann, Gerhard, Dipl.-Ing.**
**Hudeplan 10**
**D-3000 Hannover 91(DE)**

(72) Erfinder: **Uhlenhut, Heinz, Dipl.-Ing.**
**Vogelkamp 1B**
**D-3015 Wennigsen 1(DE)**

(74) Vertreter: **Einsel, Robert, Dipl.-Ing.**
**Theodor-Stern-Kai 1**
**D-6000 Frankfurt/Main 70(DE)**

(54) **Zeilenablenkschaltung für einen Fernsehempfänger.**

(57) Bei einer Zeilenablenkschaltung für einen Fernsehempfänger ist zwischen der Sekundärwicklung (5) des Treibertrafos (3) und der Basis des Zeilenendstufentransistors (8) für die erforderliche Formung des Basisstromes ein ohmscher Widerstand (7) notwendig. Dieser Widerstand (7) wird dadurch eingespart, daß der Verlustwiderstand der Sekundärwicklung (5) entsprechend groß bemessen wird. Vorzugsweise wird für die Primärwicklung (4) und die Sekundärwicklung (5) des Treibertrafos (3) der gleiche Draht verwendet. Dadurch wird die automatische Herstellung des Treibertrafos (3) beträchtlich vereinfacht.

Fig. 1

COMPLETE DOCUMENT

L  i  c  e  n  t  i  a
Patent-Verwaltungs-GmbH
Theodor-Stern-Kai  1

6000 Frankfurt / Main 70


Hannover, den 12.05.1981
Z13 PTL-Wp/rs    H 81/33

Zeilenablenkschaltung für einen Fernsehempfänger

Bei einer Zeilenablenkschaltung für einen Fernsehempfänger
wird eine zeilenfrequente Schaltspannung über einen Treibertransistor und einen Treibertrafo der Basis des Zeilenendstufentransistors zugeführt. Dieser liegt in Reihe mit dem
Zeilentransformator und erzeugt darin durch einen reinen
Schalterbetrieb einen sägezahnförmigen zeilenfrequenten
Strom, der über die Zeilenablenkspulen in der Bildröhre die
Zeilenablenkung bewirkt. Für diesen Schalterbetrieb ist es
notwendig, den Zeilenendstufentransistor am Ende der Zeilenhinlaufzeit zu sperren, damit der Zeilenrücklauf eingeleitet
wird. Diese Sperrung muß sehr schnell erfolgen, da sonst
die am Zeilenendstufentransistor auftretende Verlustleistung
zu groß wird und der Transistor gefährdet ist.

Für das einwandfreie Schaltverhalten des Zeilenendstufentransistors, insbesondere die Erzeugung einer hohen Sperrspannungsspitze zu Beginn des Zeilenrücklaufs, sind zwischen
der Sekundärwicklung des Treibertrafos und der Basis des
Zeilenendstufentransistors zusätzliche Schaltungselemente
erforderlich, die der Basisspannung und dem Basisstrom des
Zeilenendstufentransistors die notwendige Form geben.

- 3 -

Hierzu ist es bekannt, zwischen die Sekundärwicklung des Treibertrafos und die Basis des Zeilenendstufentransistors eine Induktivität einzuschalten, die durch die Änderung des Basisstromes zur Erzeugung einer hohen Spannungsspitze in Sperrichtung beiträgt. Es ist ferner notwendig, zwischen die Sekundärwicklung des Treibertrafos und die Basis des Endstufentransistors einen ohmschen Widerstand in der Größenordnung von 0,75 Ohm bis 1 Ohm einzuschalten. Dieser Widerstand dient dazu, den Basis-Steuerstrom für den Zeilenendstufentransistor zu begrenzen und die Steuerfunktion des Treibertrafos für den Zeilenendstufentransistors den Eigenschaften einer Konstantstromquelle anzunähern. Dieser Widerstand ist in der Praxis als Drahtwiderstand ausgebildet und daher relativ teuer. Ohne diesen Widerstand indessen läßt sich die angestrebte einwandfreie Ansteuerung des Zeilenendstufentransistors wegen der Streuung der Eingangsimpedanz der genannten Transistoren nicht sicher genug erreichen.

Der Erfindung liegt die Aufgabe zugrunde, die Zeilenablenkschaltung so auszubilden, daß der genannte Widerstand nicht mehr benötigt wird.

Diese Aufgabe wird durch die im Anspruch 1 beschriebene Erfindung gelöst. Vorteilhafte Weiterbildungen der Erfindung sind in den Unteransprüchen beschrieben.

Die Erfindung beruht auf der Erkenntnis, daß der genannte, relativ niederohmige Widerstand sich durch die Sekundärwicklung realisieren läßt, indem entsprechend viele Windungen oder ein entsprechend dünner Draht gewählt werden. Bei einem bevorzugten Ausführungsbeispiel wird für die Primärwicklung und für die Sekundärwicklung des Treibertrafos der gleiche Draht verwendet. Das hat den Vorteil, daß bei einer automatischen Fertigung des Treibertrafos der Wickelautomat beträchtlich einfacher ausgebildet sein kann. Außerdem wird dann für den Treibertrafo nur noch eine Drahtsorte mit einer
einzigen Drahtstärke benötigt, was Bestellung und Lagerhaltung
vereinfacht.

Gemäß einer Weiterbildung der Erfindung kann auch eine zwischen
der Sekundärwicklung des Treibertrafos und der Basis des Endstufentransistors notwendige Induktivität durch eine entsprechend
groß bemessene Streuinduktivität der Sekundärwicklung des Treibertrafos realisiert werden. Diese Streuinduktivität beträgt
bei einer Ausführungsform einer Treiberschaltung etwa 12 /uH
mit einer Toleranz von ± 1,5 /uH.

Ein Ausführungsbeispiel der Erfindung wird anhand der Zeichnung erläutert. Darin zeigen
Figur 1 die Zeilenablenkschaltung in vereinfachter Darstellung
und
Figur 2 eine konstruktive Ausführung des Treibertrafos.

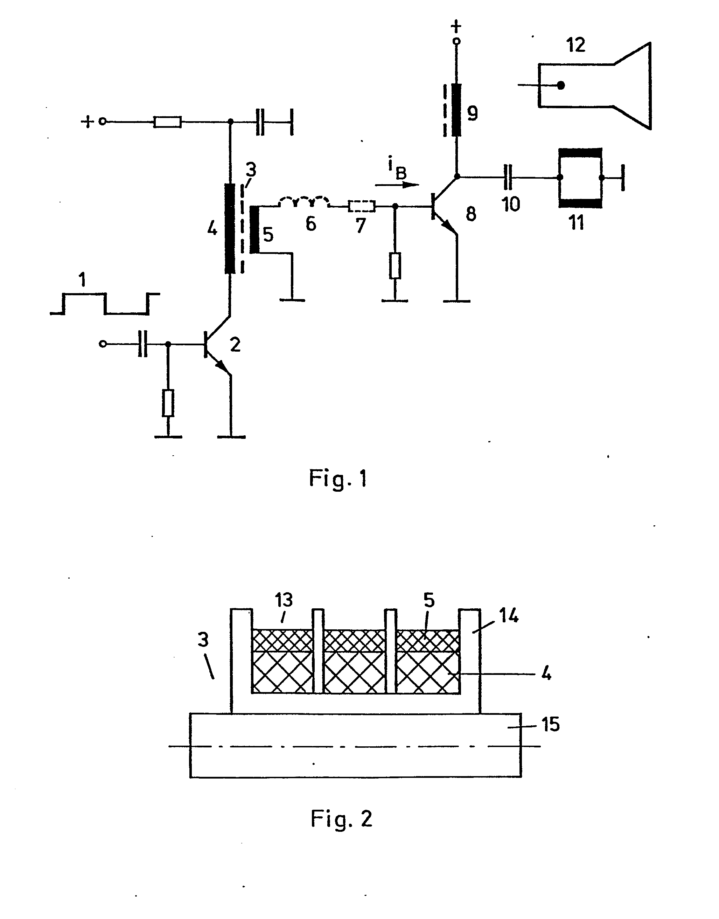

In Figur 1 wird die zeilenfrequente Schaltspannung 1 der Basis
des Treibertransistors 2 zugeführt. In dessen Kollektorkreis
liegt der Treibertrafo 3 mit der Primärwicklung 4 und der
Sekundärwicklung 5. Die Sekundärwicklung 5 ist über ein Netzwerk mit der Induktivität 6 und dem Widerstand 7 an die Basis
des Zeilenendstufentransistors 8 angeschlossen. Dessen Kollektor ist über die Wicklung 9 des Zeilentrafos an die Betriebsspannung und außerdem über den Tangenskondensator 10 an die
Zeilenablenkspulen 11 für die Bildröhre 12 angeschlossen.

Das Netzwerk 6,7 dient zur Formung des Basisstromes $i_B$ im
Sinne einer einwandfreien Steuerung des Transistors 8. Der
Widerstand 7 ist in der Schaltung als körperlicher Widerstand
nicht vorhanden, sondern durch einen entsprechend groß bemessenen Verlustwiderstand der Sekundärwicklung 5 gebildet.
Dieses läßt sich durch entsprechend viele Windungen, durch
einen Draht mit entsprechend kleinem Durchmesser oder auch durch einen Draht aus einem Material mit einem entsprechend hohen spezifischen Widerstand erreichen. Durch entsprechenden Aufbau der Wicklungen 4 und 5 kann gemäß DE-OS 22 61 060 auch die Induktivität 6 als Streuinduktivität der Wicklungen 4 und 5 realisiert und somit körperlich eingespart werden.

Figur 2 zeigt die Wicklungen 4,5 des Treibertrafos 3. Beide Wicklungen sind gleichmäßig auf drei Kammern 13 einer Kammerwicklung aufgeteilt und liegen übereinander. Der die Kammern 13 enthaltende Spulenkörper 14 ist auf den stabförmigen Kern 15 aufgeschoben. Die Wicklungen 4,5 sind jede für sich durchgehend gewickelt, und zwar beide mit dem gleichen Draht. Die Wicklung 5 hat weniger Windungen als die Wicklung 4, weil der Treibertrafo eine Spannungsverringerung und eine Stromerhöhung bewirken muß.

0065684

## Patentansprüche

1. Zeilenablenkschaltung für einen Fernsehempfänger mit einem Treibertrafo (3), dessen Sekundärwicklung (5) über ein einen ohmschen Widerstand (7) enthaltendes Netzwerk mit der Basis des Zeilenendstufentransistors (8) verbunden ist, dadurch gekennzeichnet, daß der ohmsche Widerstand (7) durch einen entsprechend groß bemessenen Verlustwiderstand der Sekundärwicklung (5) gebildet ist.

2. Schaltung nach Anspruch 1, dadurch gekennzeichnet, daß die Primärwicklung (4) und die Sekundärwicklung (5) des Trafos (3) aus dem gleichen Draht gewickelt sind.

3. Schaltung nach Anspruch 1, dadurch gekennzeichnet, daß die Wicklungen (4,5) des Trafos (3) als Kammerwicklung ausgebildet sind (Fig. 2).

4. Schaltung nach Anspruch 3, dadurch gekennzeichnet, daß die Wicklungen (4,5) gleichmäßig auf die Kammern (13) verteilt sind.

5. Schaltung nach Anspruch 1, dadurch gekennzeichnet, daß ein im Netzwerk notwendige Induktivität (6) durch eine entsprechend groß bemessene Streuinduktivität der Sekundärwicklung (5) gebildet ist.

6. Schaltung nach Anspruch 1, dadurch gekennzeichnet, daß für die Sekundärwicklung (5) ein Draht mit einem gegenüber Kupfer größeren spezifischen Widerstand verwendet ist.

- 2 -

Fig. 1

Fig. 2

0065684

Europäisches
Patentamt

**EUROPÄISCHER RECHERCHENBERICHT**

Nummer der Anmeldung

EP 82 10 3974

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| A | US-A-4 001 641  (FISCHMAN et al.) | 1,5 | H 03 K    4/64<br>H 01 F   19/00 |
| | --- | | |
| A | IEEE TRANSACTIONS ON CONSUMER ELECTRONICS, Band CE-21, Nr. 4, November 1975, Seiten 396-402, New York (USA); M.FISCHMAN et al.: "Low power consumption driver for wessel horizontal deflection system". | 1,5 | |
| | --- | | |
| A | US-A-2 962 626  (BERG et al.) | 1,5 | |
| | --- | | |
| A | INTERNATIONALE ELEKTRONISCHE RUNDSCHAU, Band 25, Nr. 1, Januar 1971, Seiten 24-26, Berlin (DE); H.BAHRING:       "Neuartige Horizontalablenkung           mit Energierückgewinnung ohne Diode". | 1 | **RECHERCHIERTE SACHGEBIETE (Int. Cl. ³)**<br><br>H 03 K<br>H 01 F |
| | --- | | |
| A,D | DE-A-2 261 060  (LICENTIA) | | |
| | ----- | | |

Der vorliegende Recherchenbericht wurde für alle Patentansprüche erstellt.

| Recherchenort | Abschlußdatum der Recherche | Prüfer |
|---|---|---|
| DEN HAAG | 31-08-1982 | GYSEN L.A.D. |